(19) **Europäisches Patentamt / European Patent Office / Office européen des brevets**

(11) **EP 4 610 393 A1**

(12) **EUROPÄISCHE PATENTANMELDUNG**

(43) Veröffentlichungstag:
**03.09.2025 Patentblatt 2025/36**

(21) Anmeldenummer: **24160350.5**

(22) Anmeldetag: **28.02.2024**

(51) Internationale Patentklassifikation (IPC):
**C23C 16/02** (2006.01)    **C23C 16/30** (2006.01)
**C23C 16/34** (2006.01)    **C23C 16/36** (2006.01)
**C23C 28/04** (2006.01)

(52) Gemeinsame Patentklassifikation (CPC):
**C23C 16/36; C23C 16/0272; C23C 16/303;**
**C23C 16/34; C23C 28/044**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **BOEHLERIT GmbH & Co.KG.**
**8605 Kapfenberg (AT)**

(72) Erfinder:
• **TRAXLER, Margarethe**
  **8053 Graz (AT)**
• **WEISSENBACHER, Ronald**
  **8600 Bruck an der Mur (AT)**

(74) Vertreter: **Wirnsberger & Lerchbaum**
**Patentanwälte OG**
**Mühlgasse 3**
**8700 Leoben (AT)**

(54) **VERFAHREN ZUM BESCHICHTEN EINES OBJEKTES UND DAMIT HERGESTELLTES OBJEKT**

(57)    Die Erfindung betrifft ein Verfahren zum Beschichten eines Objektes, insbesondere eines Schneideinsatzes wie einer Schneidplatte, wobei auf einem Grundkörper eine ein- oder mehrlagige Beschichtung abgeschieden wird, wobei zumindest eine Beschichtungslage mit einem CVD-Verfahren als $Al_xTi_{1-x}C_yN_z$-Beschichtungslage mit Stöchiometriekoeffizienten $0,67 \leq x < 1,0$, $0 \leq y < 0,1$ und $0,9 \leq z \leq 1,15$ abgeschieden wird, wobei die $Al_xTi_{1-x}C_yN_z$-Beschichtungslage in einer Reaktionszone aus einem Gemisch mit einer Vorläuferverbindung für Aluminium, einer Vorläuferverbindung für Titan und einer Vorläuferverbindung für Stickstoff sowie einer kohlenstoffhaltigen Verbindung abgeschieden wird. Um insbesondere bei Schneideinsätzen hohe Standzeiten zu erreichen, wird erfindungsgemäß die $Al_xTi_{1-x}C_yN_z$-Beschichtungslage bei einem Druck von mehr als 15 mbar und bei einer Temperatur von 750 °C bis 850 °C und einem molaren Verhältnis der Vorläuferverbindung von Aluminium zu der Vorläuferverbindung von Titan von 5,0 bis 15 und einem molaren Verhältnis der Vorläuferverbindung für Stickstoff zu der kohlenstoffhaltigen Verbindung von 0,5 bis 5,0 abgeschieden.

Die Erfindung betrifft des Weiteren ein mit einem derartigen Verfahren hergestelltes Objekt.

20 nm

**Fig. 8b**

EP 4 610 393 A1

**Beschreibung**

Die Erfindung betrifft ein Verfahren zum Beschichten eines Objektes, insbesondere eines Schneideinsatzes wie einer Schneidplatte, wobei auf einem Grundkörper eine ein- oder mehrlagige Beschichtung abgeschieden wird, wobei zumindest eine Beschichtungslage mit einem CVD-Verfahren als $Al_xTi_{1-x}C_yN_z$-Beschichtungslage mit Stöchiometrie-koeffizienten $0{,}67 \leq x < 1{,}0$, $0 \leq y < 0{,}1$ und $0{,}9 \leq z \leq 1{,}15$ abgeschieden wird, wobei die $Al_xTi_{1-x}C_yN_z$-Beschichtungslage in einer Reaktionszone aus einem Gemisch mit einer Vorläuferverbindung für Aluminium, einer Vorläuferverbindung für Titan und einer Vorläuferverbindung für Stickstoff sowie einer kohlenstoffhaltigen Verbindung abgeschieden wird.

Des Weiteren betrifft die Erfindung ein mit einem solchen Verfahren hergestelltes Objekt.

Aus dem Stand der Technik ist es bekannt, dass Schneidwerkzeuge oder Schneideinsätze zur Erhöhung einer Standzeit im Schneideinsatz mit Beschichtungslagen beschichtet werden, die aus Titan, Aluminium und Stickstoff zusammengesetzt sind. Allgemein wird diesbezüglich oftmals von TiAlN-Beschichtungslagen gesprochen, wobei eine durchschnittliche chemische Zusammensetzung, unabhängig davon, ob eine oder mehrere Phasen in der Beschichtungslage vorliegen, mit $Ti_{1-x}Al_xN$ angegeben wird. Für Beschichtungslagen, die mehr Aluminium als Titan enthalten, ist auch die Nomenklatur AlTiN bzw. genauer $Al_xTi_{1-x}N$ gebräuchlich.

Aus der WO 03/085152 A2 ist es bekannt, im System AlTiN monophasige Beschichtungslagen mit einer kubischen Struktur herzustellen, wobei bei einem relativen Anteil von Aluminiumnitrid (AlN) bis zu 67 Molprozent (Mol-%) eine kubische Struktur des AlTiN erhalten wird. Bei höheren AlN-Gehalten von bis zu 75 Mol-% entsteht ein Gemisch aus kubischem AlTiN und hexagonalem AlN und bei einem AlN-Gehalt von mehr als 75 Mol-% ausschließlich hexagonales AlN und kubisches Titannitrid (TiN). Gemäß der genannten Druckschrift werden die beschriebenen AlTiN-Beschichtungslagen mittels Physical Vapor Deposition (PVD) abgeschieden. Mit einem PVD-Verfahren sind somit maximale relative Anteile von AlN praktisch auf 67 Mol-% beschränkt, da sonst ein Umkippen in Phasen möglich ist, die Aluminium nur in Form von hexagonalem AlN enthalten. Ein höherer relativer Anteil von kubischem AlN ist jedoch nach Fachmeinung erwünscht, um eine Verschleißbeständigkeit möglichst zu maximieren.

Aus dem Stand der Technik ist es auch bekannt, anstelle von PVD-Verfahren Chemical Vapor Deposition (CVD) einzusetzen, wobei ein CVD-Verfahren bei relativ niedrigen Temperaturen im Temperaturfenster von 700 °C bis 900 °C durchzuführen ist, da kubische AlTiN-Beschichtungslagen bei Temperaturen von z. B. $\geq 1000$ °C aufgrund der metastabilen Struktur derartiger Beschichtungslagen nicht herstellbar sind. Gegebenenfalls können die Temperaturen gemäß der US 6,238,739 B1 auch noch tiefer liegen, und zwar im Temperaturfenster von 550 °C bis 650 °C, wobei allerdings hohe Chlorgehalte in der Beschichtungslage in Kauf zu nehmen sind, was sich für einen Anwendungsfall als nachteilig erweist. Man hat daher versucht, CVD-Verfahren so zu optimieren, dass mit diesen AlTiN-Beschichtungslagen mit einem hohen Anteil von Aluminium und kubischer Struktur der Beschichtungslage herstellbar sind (I. Endler et al., Proceedings Euro PM 2006, Ghent, Belgien, 23. bis 25. Oktober 2006, Vol. 1, 219). Wenngleich diese Beschichtungslagen eine hohe Mikrohärte und damit grundsätzlich günstige Eigenschaften für eine hohe Verschleißbeständigkeit im Einsatz aufweisen, so hat es sich doch erwiesen, dass eine Haftfestigkeit derartiger Beschichtungslagen zu gering sein kann. Diesbezüglich wurde daher in der DE 10 2007 000 512 B3 vorgeschlagen, unterhalb einer kubischen AlTiN-Beschichtungslage, die 3 $\mu$m dick ist, eine 1 $\mu$m dicke Beschichtungslage vorzusehen, die als Phasengradientenschicht ausgebildet ist und aus einem Phasengemisch aus hexagonalem AlN, TiN und kubischem AlTiN besteht, wobei ein kubischer AlTiN-Anteil mit nach außen hin bzw. zur (ausschließlich) kubischen AlTiN-Beschichtungslage einen steigenden Anteil aufweist. Entsprechend beschichtete Schneidplatten wurden zu einem Fräsen von Stahl eingesetzt, wobei allerdings gegenüber Beschichtungslagen, die mittels eines PVD-Verfahrens hergestellt wurden, lediglich geringe Verbesserungen einer Verschleißfestigkeit erzielt wurden.

Neben der nur geringen Verbesserung einer Verschleißfestigkeit besteht ein weiterer Nachteil einer Anbindungsschicht gemäß der DE 10 2007 000 512 B3 darin, dass die Anbindungs- bzw. Phasengradientenschicht äußerst schnell aufwächst, auch bei Versuchen im Labormaßstab (I. Endler et al., Proceedings Euro PM 2006, Ghent, Belgien, 23. bis 25. Oktober 2006, Vol. 1, 219). Dies führt bei einer Herstellung in einem größeren Reaktor, der für ein großtechnisches Beschichten von Schneidplatten ausgelegt ist, dazu, dass die Anbindungs- bzw. Phasengradientenschicht im vorgesehenen Beschichtungsprozess äußerst dick wird, da eine Temperatur zur Ausbildung der letztlich vorgesehenen kubischen AlTiN-Beschichtungslage abzusenken ist, was entsprechende Zeit erfordert. Während dieser Absenkung einer Prozesstemperatur wächst jedoch eine Dicke der Anbindungs- bzw. Phasengradientenschicht rasch an, weil in einem großtechnischen Reaktor eine schnelle Abkühlung nicht möglich ist. Denkbar wäre es, den Beschichtungsprozess für längere Zeit bzw. das Abkühlen zu unterbrechen, was allerdings nicht wirtschaftlich ist.

Aus der WO 2013/134796 A1 sind ein beschichteter Körper und ein Verfahren zum Beschichten eines Körpers bekannt geworden, wobei eine spezielle Beschichtungslage aus $Al_xTi_{1-x}N$ in einzelnen Bereichen mit einer lamellenartigen Struktur ausgebildet ist. Diese lamellenartige Struktur setzt sich aus abwechselnden Lamellen aus $Ti_{1-x}Al_xN$ (überwiegend Ti als Metall) und, damit alternierend, $Al_xTi_{1-x}N$ (überwiegend Al als Metall) zusammen. Das $Ti_{1-x}Al_xN$ liegt als kubische Phase vor, wohingegen das $Al_xTi_{1-x}N$ eine hexagonale Struktur aufweist. Obwohl an sich hexagonales AlN bzw. $Al_xTi_{1-x}N$ entsprechend den vorstehenden Ausführungen nicht erwünscht ist, hat sich in dieser speziellen Struktur das hexagonale AIN bzw. $Al_xTi_{1-x}N$ in der alternierenden Ausbildung mit kubischem TiN bzw. $Ti_{1-x}Al_xN$ als vorteilhaft erwiesen, was auf die Ausbildung der Lamellen im Nanometerbereich zurückgeführt wird.

Aus der WO 2016/112417 A1 ist es bekannt geworden, dass durch Variation der Gasflüsse auch Strukturen mit weitgehend kubischer Struktur hergestellt werden können. Dabei wechseln sich in lamellenartigen Bereichen kubische Lamellenlagen unterschiedlicher Zusammensetzung, aber jeweils mit kubischer Kristallstruktur ab. Unter bestimmten Bedingungen kann es auch zur Ausbildung hierarchischer Strukturen über mehrere Längenskalen kommen, wie dies von M. Meindlhumer et al. nachgewiesen wurde (M. Meindlhumer et al., Biometic hard and tough nanoceramic Ti-AI-N film with selfassembled 6-level hierarchy, nanoscale 16 (2019) 7986; doi:10.1039/c8nr10339a). Dabei wurde unter anderem nachgewiesen, dass die kubische Struktur als Fischgrätmuster mit kohärenten Phasenanteilen von kubischem Ti(Al)N im Wechselspiel mit kubischem Al(Ti)N vorliegt. Dabei kann gemäß der angegebenen Schreibweise die kubische Phase mit überwiegend Titan auch geringere Anteile an Aluminium enthalten und umgekehrt.

Mit ausschließlich oder zumindest überwiegend kubischen Strukturenausbildungen in der AlTiN-Beschichtungslagen werden sehr gute Standzeiten entsprechend beschichteter Schneideinsätze wie Schneidplatten erreicht. In diesem Zusammenhang ist es aus der WO 2023/164731 A1 bekannt geworden, bei der Abscheidung einer entsprechenden AlTiN-Beschichtungslage dem reaktiven Gemisch Schwefelwasserstoff beizumengen. Dadurch kann die kubische Kristallstruktur stabilisiert werden. Schwefel wird in die Beschichtungslage eingebaut und mit der Beschichtungslage werden bei Schneidplatten höhere Standzeiten eines Schneideinsatzes erzielt.

Ausgehend vom Stand der Technik ist es Aufgabe der Erfindung, ein Verfahren der eingangs genannten Art derart weiterzubilden, dass Objekte mit hoch verschleißfesten Beschichtungslagen im AlTiN-Beschichtungssystem herstellbar sind, insbesondere Schneideinsätze mit erhöhten Standzeiten.

Des Weiteren ist es ein Ziel der Erfindung, ein Objekt anzugeben, das mit einem derartigen Verfahren hergestellt ist.

Die verfahrensmäßige Aufgabe der Erfindung wird gelöst, wenn bei einem Verfahren der eingangs genannten Art die $Al_xTi_{1-x}C_yN_z$-Beschichtungslage bei einem Druck von mehr als 15 mbar und bei einer Temperatur von 750 °C bis 850 °C und einem molaren Verhältnis der Vorläuferverbindung von Aluminium zu der Vorläuferverbindung von Titan von 5,0 bis 15 und einem molaren Verhältnis der Vorläuferverbindung für Stickstoff zu der kohlenstoffhaltigen Verbindung von 0,5 bis 5,0 abgeschieden wird.

Es hat sich gezeigt, dass mit einem erfindungsgemäßen Verfahren Objekte mit einer hoch verschleißfesten Beschichtung herstellbar ist, die Standzeitverlängerungen von mehr als 20 % führen kann, ausgehend von bereits ohnehin hoch verschleißfesten Beschichtungen im AlTiN-Beschichtungssystem. Die mit dem Verfahren hergestellten $Al_xTi_{1-x}C_yN_z$-Beschichtungslagen weisen im Nanometerbereich insbesondere Kristallite mit kubischer Kristallstruktur auf, allerdings mit einer inhomogenen Elementverteilung in Bezug auf Titan, nämlich Randzonen mit höherem Titangehalt als durchschnittlich in den übrigen Kristallitbereichen, und/oder wechselweise mit titanreichen und titanarmen Schichten, die entlang einer vorgegebenen Strecke von beispielsweise weniger als 100 nm, insbesondere weniger als 60 nm, mit stark variierenden Abständen vorliegen. Dabei ist die $Al_xTi_{1-x}C_yN_z$-Beschichtungslage überraschenderweise trotz der Präsenz der kohlenstoffhaltigen Verbindung während des Abscheidens der $Al_xTi_{1-x}C_yN_z$-Beschichtungslage im Wesentlichen frei von Kohlenstoff ausgebildet, wie dies zuvor erläutert wurde, und liegt somit als $Al_xTi_{1-x}N$-Beschichtungslage vor. Auf der anderen Seite dürfte die Präsenz der kohlenstoffhaltigen Verbindung, insbesondere Ethen, die strukturelle Ausbildung im Nanometerbereich beeinflussen, wenngleich es sich diesbezüglich nur um eine Arbeitshypothese handelt.

Mit Vorteil ist vorgesehen, dass das molare Verhältnis der Vorläuferverbindung von Aluminium zu der Vorläuferverbindung von Titan 5,5 bis 12,0, vorzugsweise 6,5 bis 11,5, insbesondere 8,0 bis 11,0, beträgt.

Auf dem Grundkörper kann eine Anbindungslage aus Titannitrid abgeschieden werden. Die Anbindungslage aus Titannitrid weist üblicherweise eine Dicke von weniger als 1 μm auf, beispielsweise etwa 0,5 μm. Die Beschichtungslage aus Titannitrid ist bevorzugt mit einem CVD-Verfahren abgeschieden. Es können weitere Anbindungslagen oder Zwischenlagen folgen, ehe die $Al_xTi_{1-x}C_yN_z$-Beschichtungslage aufgebracht wird.

Bevorzugt werden alle Beschichtungslagen in einem CVD-Verfahren abgeschieden, sodass alle Beschichtungslagen nacheinander in einem Reaktor erfolgen können, indem lediglich das Prozessgas geändert wird. Bevorzugt werden die einzelnen Beschichtungslagen dabei so abgeschieden, dass die Temperaturen während nachfolgender Beschichtungsschritte gleich oder niedriger sind. Somit kann eine Abfolge von Beschichtungslagen im Reaktor erstellt werden, ohne dass während der Abscheidung einer Beschichtungslage eine Temperaturerhöhung erfolgen muss.

Bevorzugt kommt Ethen als kohlenstoffhaltige Verbindung zum Einsatz, wenngleich auch andere kohlenstoffhältige Verbindungen wie beispielsweise Acetonitril Einsatz finden könnten.

Die $Al_xTi_{1-x}C_yN_z$-Beschichtungslage kann mit $y < 0,05$, insbesondere $y \leq 0,01$, vorzugsweise $y \leq 0,001$, abgeschieden werden. Trotz der Präsenz eines Reaktionsgases wie Ethen wird unter den vorgegebenen Reaktionsbedingungen im Wesentlichen kein Kohlenstoff in die AlTiN-Beschichtungslage eingebaut.

Bevorzugt kann vorgesehen sein, dass die $Al_xTi_{1-x}C_yN_z$-Beschichtungslage mit einem molaren Verhältnis der Vorläuferverbindung für Stickstoff zu der kohlenstoffhaltigen Verbindung von 1,0 bis 3,0, vorzugsweise 1,25 bis 2,5, abgeschieden wird. In diesen Abscheidungsbereichen betreffend das molare Verhältnis stellt sich eine ungewöhnliche Struktur im Nanometerbereich der Beschichtungslage ein.

Die $Al_xTi_{1-x}C_yN_z$-Beschichtungslage kann bei einem Druck von 10 mbar bis 150 mbar beispielsweise von 20 mbar bis 80 mbar, insbesondere 30 mbar bis 65 mbar, abgeschieden werden. Diese Drücke sind im Vergleich mit einer Abscheidung unter niedrigen Drücken (I. Endler et al., Aluminium-rich TiAlCN coatings by Low Pressure CVD, Surface & Coatings Technology 205 (2010) 1307) relativ hoch.

Eine Temperatur für die Abscheidung der $Al_xTi_{1-x}C_yN_z$-Beschichtungslage liegt üblicherweise im Bereich von 780 °C bis 850 °C, bevorzugt im Bereich von etwa 800 °C bis 835 °C.

Das weitere Ziel der Erfindung wird durch ein Objekt erreicht, welches durch ein erfindungsgemäßes Verfahren erhältlich ist. Ein Objekt mit einer entsprechenden $Al_xTi_{1-x}C_yN_z$-Beschichtungslage zeichnet sich durch eine außergewöhnliche Struktur im Nanometerbereich aus. Überraschenderweise weist die auf dem Objekt abgeschiedene $Al_xTi_{1-x}C_yN_z$-Beschichtungslage trotz der Präsenz von Ethen während des Abscheidens dieser Beschichtungslage im Wesentlichen keinen Kohlenstoff auf, obwohl zu erwarten wäre, dass Kohlenstoff signifikant Stickstoff in dieser Beschichtungslage substituiert, wenn beispielsweise Ethen während des Abscheidens der entsprechenden Beschichtungslage mit CVD anwesend ist. Darüber hinaus können in der $Al_xTi_{1-x}C_yN_z$-Beschichtungslage erste Bereiche mit überwiegend hexagonaler Kristallstruktur und zweite Bereiche mit zumindest überwiegend kubischer Kristallstruktur vorliegen, wobei in den zweiten Bereichen Kristallite vorliegen, die außenseitig einen höheren Titangehalt als in den übrigen Kristallitbereichen aufweisen und/oder von einem Zentrum nach außen hin mit Abschnitten höherer und niedrigerer Titangehalte ausgebildet sind, wobei die Abschnitte niedrigerer Titangehalte in einem Kristallit zumindest teilweise unterschiedlich breit sind. Die Breite der Abschnitte kann stark variieren.

Die im Objekt vorliegenden Kristallite der kubischen Phase können so ausgebildet sein, dass diese außenseitig mit einem Rand mit erhöhtem Titangehalt im Vergleich mit den übrigen Bereichen des jeweiligen Kristallites ausgebildet sind. Diese Kristallite sind dabei lamellenfrei ausgebildet, weisen also keine für entsprechende AlTiN-Beschichtungslagen typischen Abfolgen von Schichten verschiedener Phasen im Nanometerbereich auf. Vielmehr handelt es sich um Kristallite mit einer Randschicht mit einem Titangehalt, der höher als der durchschnittliche Titangehalt in den restlichen Kristallitbereichen ist. Darüber hinaus oder alternativ können die Kristallite auch von einem Zentrum nach außen hin mit Abschnitten höherer und niedrigerer Titangehalte ausgebildet sein, wobei die Abschnitte niedrigerer Titangehalte in einem Kristallit zumindest teilweise unterschiedlich breit sind. Anders als bei bekannten Lamellenabfolgen mit konstanten Breiten entsprechender Abfolgen von Abschnitten aus Ti(Al)N und Al(Ti)N, in welchen die einzelnen Abschnitte im Wesentlichen konstante Breite aufweisen, sind erfindungsgemäß die einzelnen Abschnitte niedrigerer Titangehalte zumindest teilweise unterschiedlich breit. Die Breiten der einzelnen Abschnitte variieren zumindest um das Zweifache, bevorzugt zumindest um das Fünffache. Unterschiedlich breit bedeutet in diesem Zusammenhang, dass sich die Breiten der Abschnitte niedrigerer Titangehalte in einem Kristallit zumindest um 5 nm, vorzugsweise zumindest 10 nm, insbesondere 15 nm, unterscheiden können. Dementsprechend variieren die Abstände zwischen den Maxima der Abschnitte mit höheren Titangehalten.

Mit der erfindungsgemäß vorgesehenen Ausbildung des Objektes kann insbesondere ein Schneideinsatz wie eine Schneidplatte mit einer besonders hohen Verschleißfestigkeit bereitgestellt werden. Hierfür dürfte die spezielle Ausbildung der Beschichtungslage mit den zweiten Bereichen mit überwiegend oder im Wesentlichen ausschließlicher kubischer Kristallstruktur mitbestimmend sein.

Es hat sich gezeigt, dass zumindest ein Teil der Kristallite der zweiten Bereiche zumindest teilweise in dem ersten Bereich eingebettet ist, wobei der erste Bereich angrenzend an den zweiten Bereich mit Lamellen ausgebildet ist. Dabei können die zweiten Bereiche gegebenenfalls vollständig von ersten Bereichen mit einer Lamellenstruktur umgeben sein.

Die ersten Bereiche können eine Lamellenfolge mit hexagonalem $Al_xTi_{1-x}N$ und kubischem $Al_xTi_{1-x}N$ aufweisen.

Es hat sich gezeigt, dass gute Standzeiten bei Schneideinsätzen erreicht werden, wenn ein Anteil an den zweiten Bereichen mit zumindest überwiegend kubischer Kristallstruktur 20 % bis 60 %, bevorzugt 25 % bis 55 %, insbesondere 28 % bis 45 %, beispielsweise 30 % bis 40 %, beträgt. Der Rest bzw. zweite Bereich ist zumindest überwiegend mit hexagonaler Kristallstruktur ausgebildet, wobei im Nanometerbereich auch die erwähnten Lamellen mit abwechselnd hexagonaler und kubischer Struktur vorliegen können. Interessanterweise können bei einer entsprechenden Ausbildung der $Al_xTi_{1-x}C_yN_z$-Beschichtungslage trotz relativ hohem Anteil hexagonaler Phase sehr lange Standzeiten im Vergleich mit im AlTiN-Beschichtungslagen erhalten werden, die zu mehr als 80 Volumenprozent (Vol.-%) kubisch ausgebildet sind.

Zumindest einzelne der Bereiche mit kubischer Kristallstruktur können entlang einer Längsrichtung variierende Titangehalte aufweisen, wobei ein maximaler Titangehalt einen minimalen Titangehalt um zumindest ein Zweifaches, vorzugsweise zumindest ein Vierfaches, insbesondere zumindest ein Fünffaches, beispielsweise zumindest ein Siebenfaches, übersteigt. Mit anderen Worten können die Titangehalte entlang einer Strecke von weniger als 200 nm, vorzugsweise weniger als 150 nm, beispielsweise weniger als 100 nm, schichtweise mit sehr stark variierendem Titangehalt ausgebildet sein. In der Abfolge einzelner kubischer Schichten entlang einer gewählten Strecke liegen somit Schichten mit höherem Aluminiumanteil vor, die sich mit Schichten abwechseln, in welchen ein deutlich niedrigerer Aluminiumgehalt, aber ein deutlich höherer Titangehalt vorliegt. Dabei können die einzelnen Schichten mit erhöhtem Titangehalt entlang der Strecke variierende Abstände voneinander aufweisen, die im Bereich von beispielsweise 3 nm bis 50 nm liegen. Im Unterschied zu bekannten Beschichtungslagen im AlTiN-CVD-System ist entlang einer Strecke auf der Nanometerskala die Abfolge der wechselweise vorliegenden Schichten nicht regulär, sondern folgt mit unterschiedlichen Abständen keinem erkennbaren Muster.

Die $Al_xTi_{1-x}C_yN_z$-Beschichtungslage wird in einem CVD-Verfahren hergestellt. In diesem Verfahrensschritt wird eine reaktive Kohlenstoffverbindung beigemengt, insbesondere Ethen. Dennoch kann bei entsprechender Verfahrensführung die $Al_xTi_{1-x}C_yN_z$-Beschichtungslage mit y < 0,05, insbesondere y ≤ 0,01, vorzugsweise y ≤ 0,001, ausgebildet sein. Dies ist völlig überraschend, da Kohlenstoff in dieser Beschichtungslage aufgrund einer wesentlichen Präsenz von Ethen während des Beschichtens als signifikanter Bestandteil der Beschichtungslage zu erwarten wäre. Anders als im Stand der Technik (I. Endler et al., *supra*) können aber trotz relativ starker Präsenz von Ethen während des Abscheidungsprozesses im Wesentlichen kohlenstofffreie $Al_xTi_{1-x}C_yN_z$-Beschichtungslage hergestellt werden, somit Beschichtungslagen in welchen innerhalb von Nachweisgrenzen y = 0 ist. Insbesondere können diese Beschichtungslagen so ausgebildet sein, dass mit Massenspektroskopie kein Kohlenstoff über den 100 ppm hinaus nachweisbar ist. Obwohl also eine Kohlenstoffquelle wie Ethen als reaktives Gas bei der Abscheidung einer AlTiN Beschichtungslage eingesetzt wird und sich dadurch im Vergleich mit dem Stand der Technik die Struktur der Beschichtungslage im Nanometerbereich ändert, kann in der Beschichtungslage kein Kohlenstoff in Konzentrationen festgestellt werden, die oberhalb von 100 ppm liegen.

Eine Ausbildung der ersten Bereiche und zweiten Bereiche kann so gegeben sein, dass ein Chlorgehalt in den zweiten Bereichen niedriger ist als in den ersten Bereichen.

Weitere Merkmale, Vorteile und Wirkungen der Erfindung ergeben sich aus den nachfolgend dargestellten Ausführungsbeispielen. In den Zeichnungen, auf welche dabei Bezug genommen wird, zeigen:

Fig. 1 eine schematische Darstellung eines Teils eines beschichteten Objektes;
Fig. 2 Röntgendiffraktogramme;
Fig. 3 ein gefittetes Röntgendiffraktogramm;
Fig. 4 eine STEM-Aufnahme einer ersten $Al_xTi_{1-x}C_yN_z$-Beschichtungslage;
Fig. 5 eine weitere STEM-Aufnahme einer ersten $Al_xTi_{1-x}C_yN_z$-Beschichtungslage;
Fig. 6 eine weitere STEM-Aufnahme einer ersten $Al_xTi_{1-x}C_yN_z$-Beschichtungslage mit vergrößerten Ausschnitten im Nanometerbereich;
Fig. 7a und Fig. 7b Elektronenbeugungsbilder zu Bereichen in Fig. 6;
Fig. 8a eine STEM-Aufnahme einer ersten $Al_xTi_{1-x}C_yN_z$-Beschichtungslage (Hellfeld);
Fig. 8b eine STEM-Aufnahme einer ersten $Al_xTi_{1-x}C_yN_z$-Beschichtungslage (Dunkelfeld);
Fig. 9 einen vergrößerten Ausschnitt aus Fig. 8b;
Fig. 10 bis Fig. 19 verschiedene STEM-Aufnahmen einer zweiten $Al_xTi_{1-x}C_yN_z$-Beschichtungslage, wobei teilweise EDX-Spektren überlagert sind;
Fig. 20 EDX-Spektren entlang Wegstrecken für verschiedene Richtungen entsprechend den eingezeichneten Pfeilen;
Fig. 21 eine STEM-Aufnahme mit eingezeichneten Bereichen;
Fig. 22 und Fig. 23 weitere STEM-Aufnahmen.

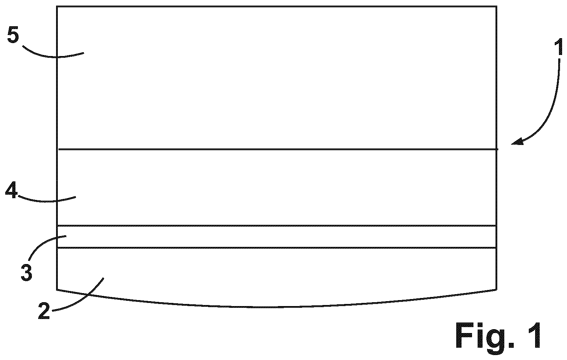

In Fig. 1 ist stark schematisiert ein Teil eines Objektes 1 dargestellt. Das Objekt 1 weist einen Grundkörper 2 auf. Der Grundkörper 2 besteht in der Regel aus einem Hartmetall, kann aber auch ein Cermet oder ein Schnellarbeitsstahl sein. Üblicherweise besteht der Grundkörper 2 aus einem Hartmetall auf Basis Wolframcarbid sowie Cobalt, Nickel und/oder Eisen als Bindemetall. Typischerweise kann der Grundkörper 2 80 Gewichtsprozent (Gew.-%) bis 90 Gew.-% Wolframcarbid, Rest Bindemetall, insbesondere Cobalt, aufweisen.

Auf den Grundkörper 2 kann eine Anbindungsschicht 3 abgeschieden sein. Die Anbindungsschicht 3 besteht üblicherweise aus Titannitrid. Die Anbindungsschicht 3 weist üblicherweise eine Dicke von weniger als 1 μm auf. Im Anschluss an die Beschichtungslage aus Titannitrid können weitere Beschichtungslagen folgen. Es kann aber auch vorgesehen sein, dass eine $Al_xTi_{1-x}C_yN_z$-Beschichtungslage 4 sogleich auf die Anbindungsschicht 3 aus Titannitrid abgeschieden ist. Bei Bedarf können auf der $Al_xTi_{1-x}C_yN_z$-Beschichtungslage 4 eine oder mehrere weitere Beschichtungslagen 5 abgeschieden sein, insbesondere aus $Al_2O_3$.

$Al_xTi_{1-x}C_yN_z$-Beschichtungslagen 4 können in einem CVD-Reaktor (zum Beispiel des Typs Bernex Ionbond) abgeschieden werden. In der nachstehenden Tabelle 1 sind typische Reaktionsparameter angegeben. Wie ersichtlich wird während der Abscheidung der $Al_xTi_{1-x}C_yN_z$-Beschichtungslage auch Ethen als reaktives Gas in den Reaktor und die Reaktionszone eingebracht. Die Precursorverbindungen für Al und Ti werden gesondert in die Reaktionszone, in welcher sich zu beschichtende Schneidplatten befinden, eingeführt, um eine vorzeitige Reaktion zu vermeiden. $TiCl_4$ wird aus der flüssigen Phase durch Verdampfen zugeführt. $AlCl_3$ wird *in situ* durch Reaktion von HCl mit Aluminiumpellets oder Aluminiumdraht generiert. Demensprechend beziehen sich die Angaben in Tabelle 1 entweder auf die Gasflüsse (l/min) oder das verdampfte Volumen (ml/min für $TiCl_4$). Tabelle 2 gibt allgemeine Parameter der Beschichtungslagen gemäß Tabelle 1 wieder.

**Tabelle 1:** Beispielhafte Reaktionsbedingungen für eine Beschichtung mit einer $Al_xTi_{1-x}C_yN_z$-Beschichtungslage abgeschieden unter Präsenz in der Gasmischung

| | Temperatur [°C] | Gaszusammensetzung/Gasfluss [l/min] bzw. $TiCl_4$ [ml/min] |
|---|---|---|
| Beschichtungslage | | |
| TiN | 880 - 900 | $TiCl_4$/2,7, $N_2$/14, $H_2$/17 |
| $Al_xTi_{1-x}C_yN_z$ | 800 - 830 | HCol-$AlCl_3$/2,7-0,9, $TiCl_4$/0,3, $NH_3$-$N_2$/0,9-4,5, $H_2$/64, Ethen/0,3 |

**Tabelle 2:** Allgemeine Parameter der Beschichtungslagen erstellt gemäß Tabelle 1

| Beschichtungslage | Schichtdicke [μm] | | Zusammensetzung |
|---|---|---|---|
| | allgemein | bevorzugt | |
| TiN | $\leq 2$ | 0,25 - 0,75 | TiN |
| $Al_xTi_{1-x}C_yN_z$ | 1 - 10 | 3-8 | $Al_xTi_{1-x}C_yN_z$, $x = 0,80 - 0,99$ $y \leq 0,001$ $z = 0,98 - 1,15$ |

Um bei der Abscheidung von $Al_xTi_{1-x}C_yN_z$-Beschichtungslagen 4 entsprechend den vorstehenden Ausführungen Kohlenstoff in die $Al_{1-x}Ti_xN$-Beschichtungslagen 4 einzubauen, wurde eine $Al_xTi_{1-x}C_yN_z$-Beschichtungslage 4 mit verschiedenen Gehalten von Ethen während der Abscheidung erzeugt. In der nachstehenden Tabelle 3 sind entsprechende Reaktionsbedingungen im Detail angeführt, wobei eine TiN-Beschichtungslage als Anbindungslage vorgesehen ist.

**Tabelle 3:** Reaktionsbedingungen für die Abscheidung von $Al_xTi_{1-x}C_yN_z$-Beschichtungslagen unter Anwesenheit von Ethen

| | | TiN | AlTiN | AlTiN |
|---|---|---|---|---|
| Chargentemperatur | [°C] | 890 | 800 | 800 |
| Zeit | [min] | 39 | 36 | 10 |
| $AlCl_3$-Temperatur Generator | [°C] | 365 | 365 | 365 |
| $AlCl_3$-Fluss | [l/min] | 0 | 3,8 | 3,6 |
| $AlCl_3$-H2-Fluss | [l/min] | 0 | 6 | 5,5 |
| HCl-Bypass-Fluss | [l/min] | 0 | 0,35 | 0,35 |
| $N_2$-Fluss | [l/min] | 14 | 5,5 | 5,5 |
| $H_2$-Fluss | [l/min] | 17 | 55 | 55 |
| $TiCl_4$-Fluss | [ml/min] | 2,2 | 0,65 | 0,5 |
| **Ethen-Fluss Beispiel 1** | [ml/min] | 0 | 0,3 | 0,2 |
| **Ethen-Fluss Beispiel 2** | [ml/min] | 0 | 0,6 | 0,4 |
| $NH_3$-Fluss | [l/min] | 0 | 1 | 1 |
| $NH_3$-$N_2$-Fluss | [l/min] | 0 | 5,5 | 5,5 |
| Druck | [mbar] | 80 | 25 | 25 |

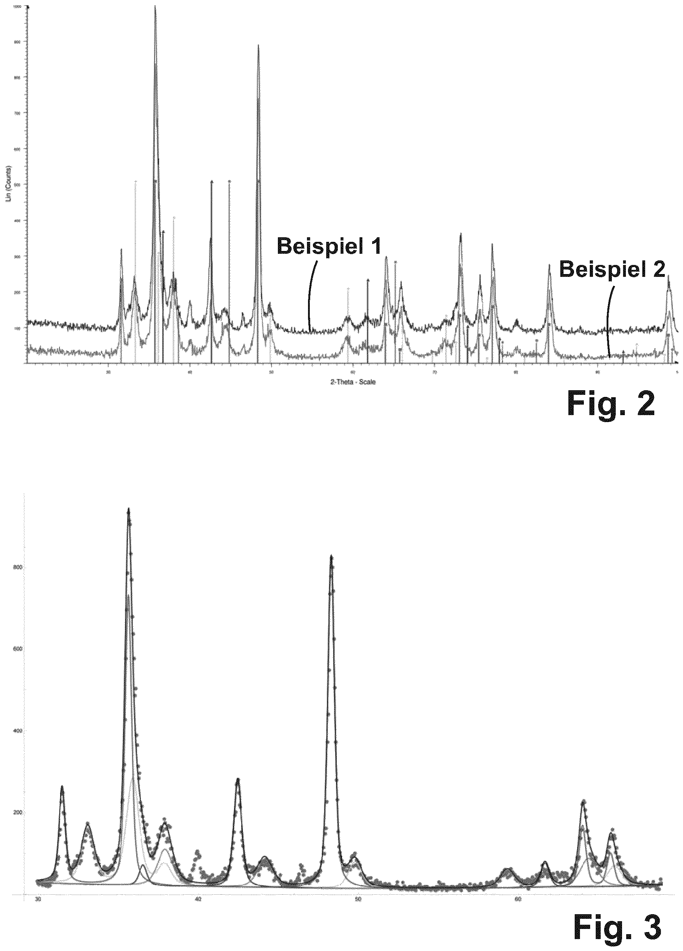

Fig. 2 sind Röntgendiffraktogramme für Beispiel 1 und Beispiel 2 dargestellt. Fig. 3 zeigt exemplarisch ein gefittetes Röntgendiffraktogramm. Aus dem Fit der Röntgendiffraktogramme ergibt sich für Beispiel 1 ein Anteil einer kubischen Fraktion der $Al_xTi_{1-x}C_yN_z$-Beschichtungslage 4 von 35 Vol.-% bis 40 Vol.-%. Für das Beispiel 2 ergibt sich aus dem entsprechenden Fit ein Anteil an kubischer Fraktion der $Al_xTi_{1-x}C_yN_z$-Beschichtungslage 4 von etwa 30 Vol.-%.

$Al_xTi_{1-x}C_yN_z$-Beschichtungslage 4 gemäß Beispiel 1 und Beispiel 2 wurden mit hochauflösenden transmissionselektronenmikroskopischen Methoden untersucht. Neben der Transmissionselektronenmikroskopie (TEM) kam auch Raster-Transmissionselektronenmikroskopie (STEM) zur Anwendung. Insbesondere wurden auch STEM-Techniken in sogenannten im High-Angle Annular Dark Field (HAADF)-Modus durchgeführt. Die Ergebnisse sind nachfolgend für die Beispiele 1 und 2 dargestellt.

Beispiel 1

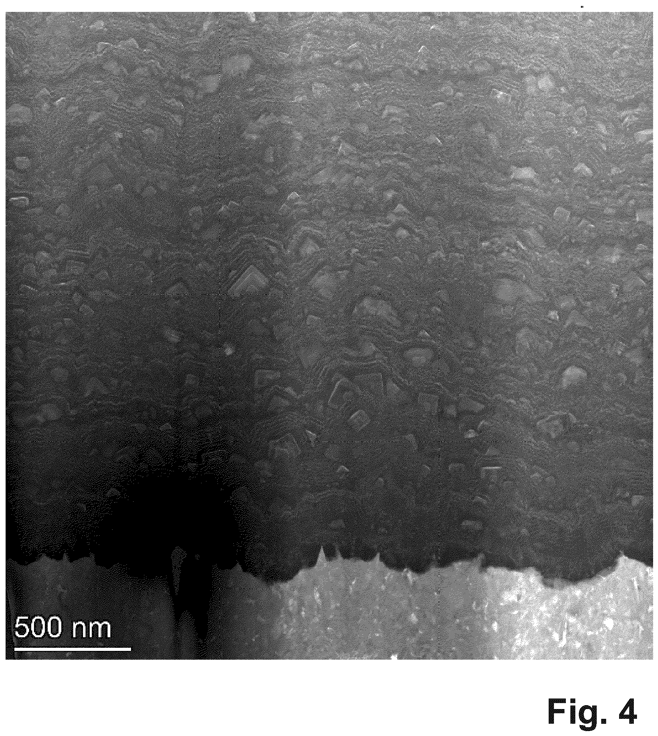

In Fig. 4 ist eine typische STEM-HAADF-Aufnahme gezeigt. Es ist ersichtlich, dass in Teilbereichen eine lamellare Struktur vorliegt, die nur auf kürzeren Längenskalen geordnet scheint. Eingebettet in die lamellaren Strukturen sind Kristallite ersichtlich.

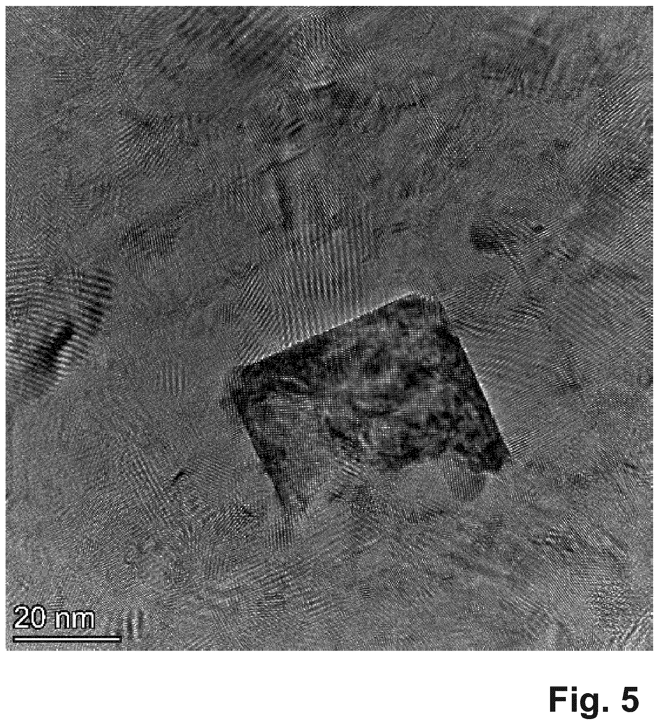

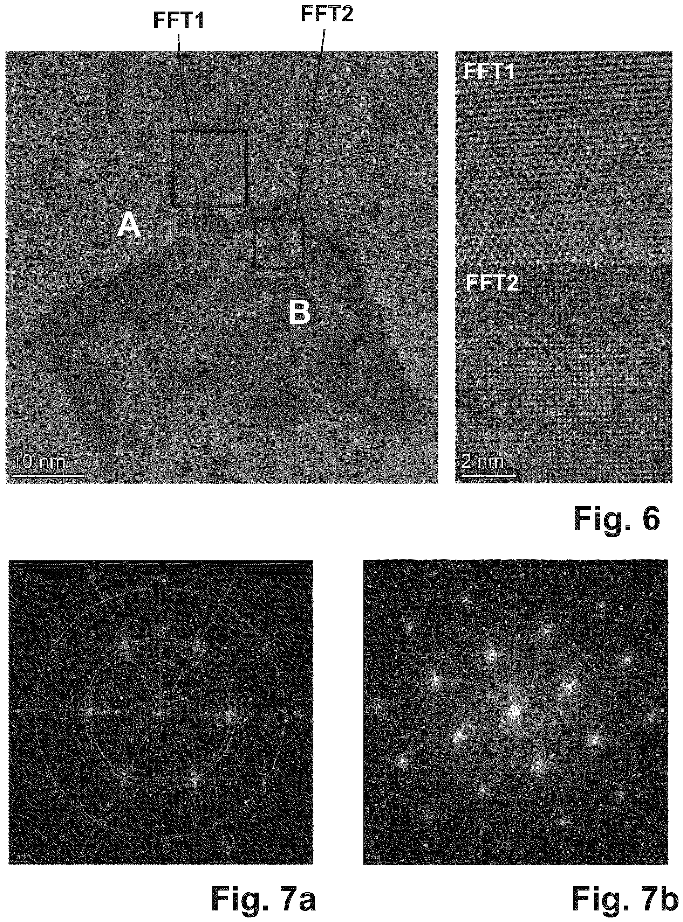

Fig. 5 zeigt eine hochauflösende (HR-)TEM-Aufnahme, die in Fig. 6 nochmals zusammen mit zwei Ausschnitten in den in Fig. 6 hervorgehobenen Bereichen (FFT1 und FFT2) dargestellt ist. In Fig. 7a und Fig. 7b sind für die entsprechenden Bereiche die Elektronenbeugungsbilder dargestellt. Fig. 7a entspricht dabei einer Elektronenbeugung im Bereich FFT 1, Fig. 7b einer Elektronenbeugung im Bereich FFT 2. Aus den HR-TEM-Aufnahmen ist in Zusammenschau mit den Elektronenbeugungsbildern ableitbar, dass außerhalb des etwa in der Bildebene quadratisch ausgebildeten Kristallites, der in Fig. 5 dunkel und abgegrenzt von einer Umgebung erscheint, eine lamellare Struktur vorliegt. In diesem Bereich A (Fig. 6) ist ein Kristallgitter gegeben, welches nahe der hexagonalen Phase von Aluminiumnitrid liegt. Für den Kristallit im Bereich B ergibt sich ein Gitter, welches die kubische Phase $Al_xTi_{1-x}N$ im Wesentlichen trifft. Der Kristallit in Fig. 6 ist somit mit einer kubischen Kristallstruktur ausgebildet und von einer lamellenartigen Struktur umgeben. Die lamellenartige Struktur kann dabei wie im Stand der Technik mit einer Abfolge aus Lamellen aus hexagonalem Al(Ti)N und gegebenenfalls dünner ausgebildeten Lamellen aus kubischem Ti(Al)N ausgebildet sein.

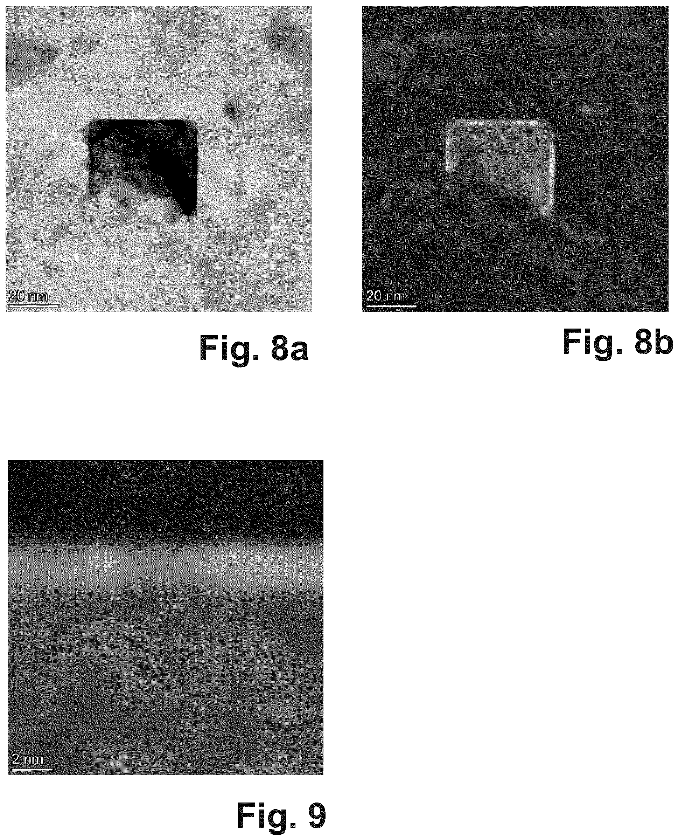

In Fig. 8a und Fig. 8b ist der Kristallit aus Fig. 5 und Fig. 6 in einer Hellfeld-Aufnahme (Fig. 8a) sowie einer Dunkelfeld-Aufnahme (Fig. 8b) gezeigt. Aus den entsprechenden STEM-Aufnahmen sowie den Ergebnissen der Elektronenbeugung geht hervor, dass der Kristallit nicht mit Lamellen aufgebaut ist. Allerdings weist der Kristallit am Rand eine insbesondere in Fig. 8b hell ersichtliche Zone auf, in welcher eine Titananreicherung vorliegt. In dieser titanreichen Zone ist der Titangehalt höher als im davon abgegrenzten zentralen Bereich, welcher durchschnittlich im Vergleich mit der Randzone weniger Titan aufweist. Die Randzone ist weniger als 5 nm dick, insbesondere weniger als 3 nm, wie dies aus Fig. 9 für einen vergrößerten Ausschnitt einer Randzone in Fig. 8b ersichtlich ist.

Es liegt somit für Beispiel 1 zumindest bereichsweise eine Struktur vor, in welcher kubische Kristallite, die lamellenfrei ausgebildet sind, mit einer titanreichen Randzone ausgebildet sind, wobei die Kristallite von einer hexagonalen Phase mit lamellarem Aufbau zumindest bereichsweise umgrenzt sind.

Beispiel 2

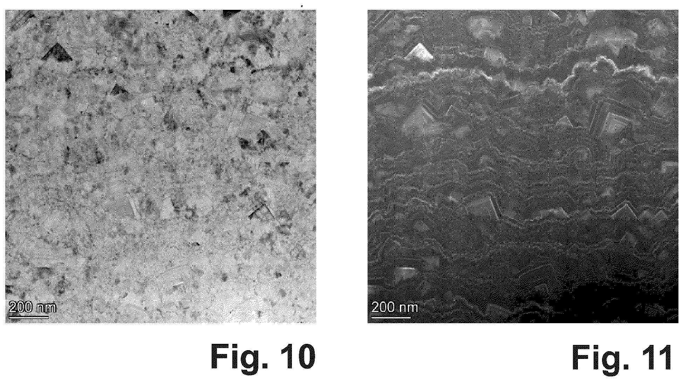

In Fig. 10 und Fig. 11 sind für Beispiel 2 STEM-Aufnahmen gezeigt, und zwar im Hellfeld (Fig. 10) sowie im Dunkelfeld (Fig. 11). Ähnlich wie für Beispiel 1 ist bei geringerer Vergrößerung eine etwa lamellare Struktur als Überstruktur ersichtlich, welche der von M. Meindlhumer et al., *supra* berichteten Struktur ähnlich ist. Allerdings erscheint diese Überstruktur im Vergleich mit der von Meindlhumer et al. berichteten wesentlich weniger geordnet.

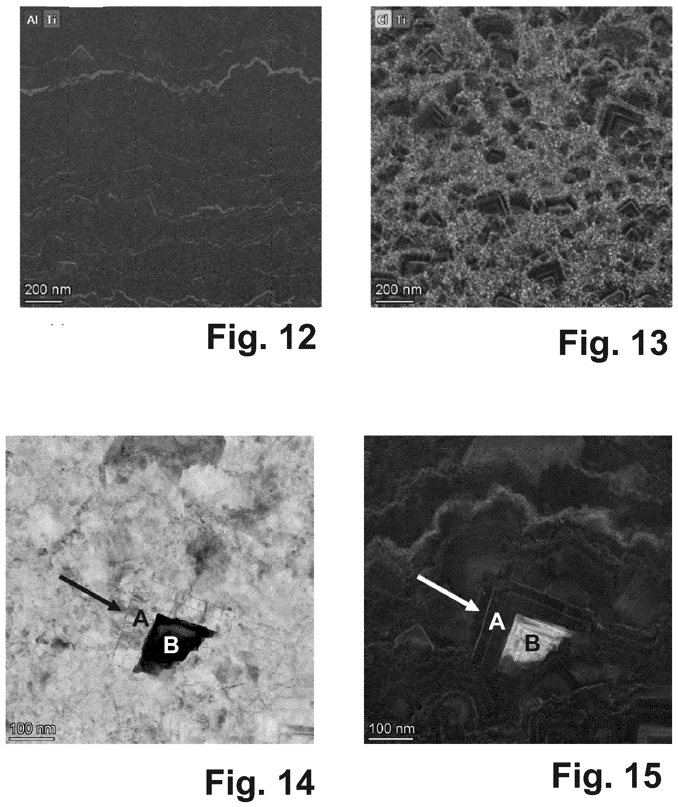

Die in Fig. 10 plättchenförmig erscheinenden Strukturen wurden weiter untersucht. In Fig. 12 und Fig. 13 sind EDX-Element-Mappings über die Aufnahmen aus Fig. 10 und Fig. 11 gelegt. In Fig. 12 sind die Elemente Aluminium und Titan hervorgehoben (Al-K und Ti-K) und in Fig. 13 Chlor und Titan (Cl-K und Ti-K). Ähnlich wie in M. Meindlhumer et al., *supra* ist ein hierarchischer Aufbau der Beschichtungslage aus $Al_xTi_{1-x}C_yN_z$ erkennbar.

In Fig. 14 und Fig. 15 ist ähnlich wie für Beispiel 1 eine Hellfeldaufnahme (Fig. 14) und eine Dunkelfeldaufnahme (Fig. 15), jeweils im STEM-Modus gezeigt, wobei ein Kristallit im Bereich A ersichtlich ist, der von einem Bereich B umgeben ist. Die Pfeile in Fig. 14 und Fig. 15 zeigen auf einen Bereich A mit einer lamellaren Struktur mit aluminiumreichen und titanreichen Abschnitten hin. Der Bereich A umschließt zumindest teilweise einen Bereich B.

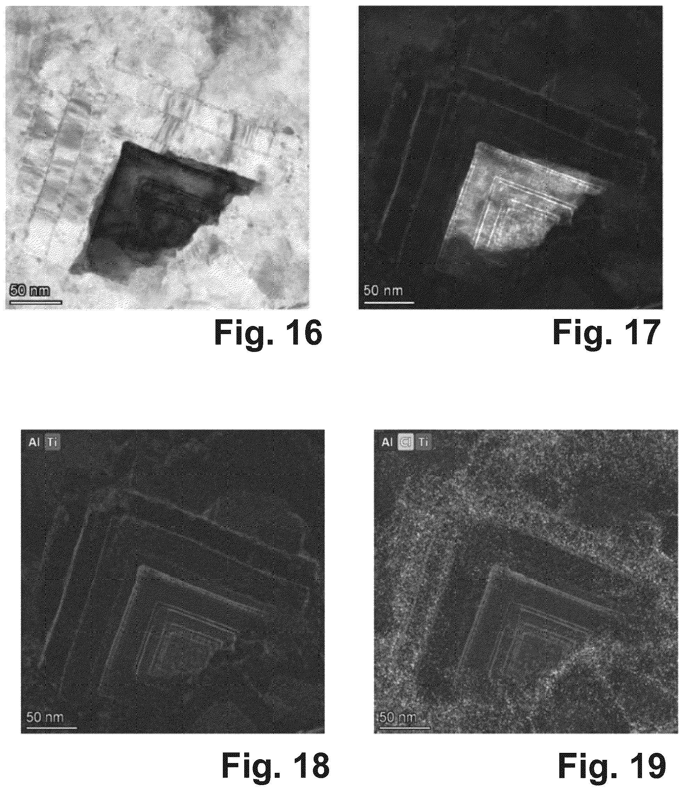

Fig. 16 und Fig. 17 zeigen vergrößerte STEM-Aufnahmen im Hellfeld (Fig. 16) und Dunkelfeld (Fig. 17). Fig. 18 zeigt über die Aufnahmen aus Fig. 16 gelegte Verteilungen aus EDX-Spektren für Aluminium und Titan (Al-K und Ti-K); Fig. 19 zeigt Entsprechendes für Fig. 17 und die Elemente Aluminium, Chlor und Titan (Al-K, Cl-K und Ti-K). Es ist ersichtlich, dass im Zentrum des Kristallits hell erscheinende titanreiche Abschnitte vorliegen, wobei Abstände zwischen diesen titanreichen Abschnitten variiert.

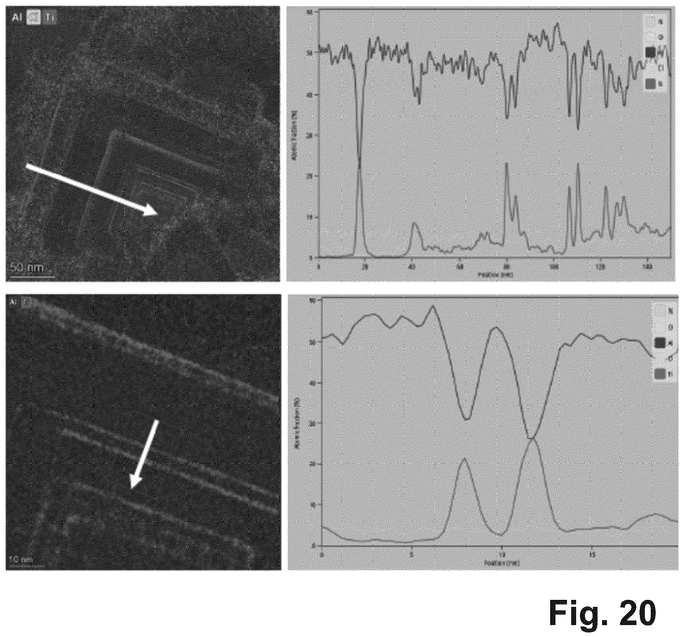

In Fig. 20 sind auf der rechten Seite zwei Profile betreffend die chemische Zusammensetzung entlang einer Messrichtung, wie diese in der jeweils korrespondierenden Abbildung links durch die Pfeile eingezeichnet ist, ersichtlich. Verfolgt man die Titankonzentration (untere Linien in den Diagrammen rechts), so ist ersichtlich, dass im Bereich einer zumindest überwiegend hexagonalen Phase bzw. im Bereich B ein Abstand zwischen einzelnen titanreichen Schichten bedeutend größer ist als im Zentrum bzw. im Bereich B. Darüber hinaus ist ein Abstand der titanreichen Schichten im Bereich B stark variierend. Es sind geringe Abstände zwischen titanreichen Schichten von wenigen nm im einstelligen Bereich gegeben, an welche breitere Abschnitte anschließen, die aluminiumreich sind, ehe wieder zwei oder mehr titanreiche Schichten in kurzen Abständen von wiederum wenigen nm (weniger als 10 nm) aufeinanderfolgen.

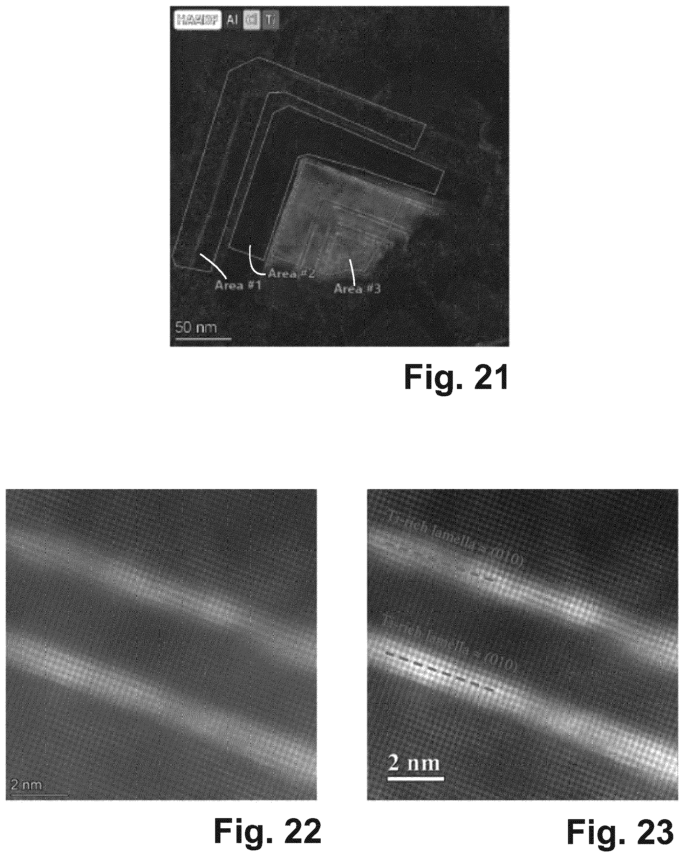

Durch eine Kombination von STEM-HAADF-Aufnahmen und STEM-EDX-Spektren konnten einzelne Phasen im Bereich A und im Bereich B ermittelt werden. Es wurden drei verschiedene Phasen gemäß Fig. 21 ermittelt. Im Bereich Area #1 ist eine hexagonale Phase gegeben, die reich an Chlor ist. In der Area #2 ist eine hexagonale Phase gegeben. In der Area #3 schließlich ist eine kubische Phase vorliegend.

Fig. 22 und Fig. 23 zeigen STEM-HAADF-Aufnahmen mit hoher Auflösung im Bereich B. Die titanreichen Schichten sind ersichtlich. Die titanreichen Schichten wechseln sich mit aluminiumreichen Schichten ab, die etwa 5 bis 6 Gitterebenen dick sind. Die helleren titanreichen Schichten sind deutlich dünner ausgebildet.

Weitere Untersuchungen haben gezeigt, dass es sich im Zentrum des untersuchten Kristallites um ein kubisch raumzentriertes Gitter handelt, welches Gitterparameter ähnlich der bekannten kubisch-raumzentrierten $Ti_{1-x}Al_xN$-Struktur von Endler et al., publiziert in Powder diffraction data of aluminium-rich fcc $T_{1-x}Al_xN$ prepared by CVD, Coatings 11 (2021) 683; doi.org/10.3390/coatings11060683, entspricht. Die außenseitig anliegende zumindest überwiegend hexagonale Phase weist Schichtabfolgen auf, in welchen abwechselnd titanreichere und aluminiumreichere Schichten vorliegen.

Chemische Zusammensetzung

Für die Bestimmung der chemischen Zusammensetzung wurde Atomsondentomographie verwendet. Dabei konnten Zusammensetzungsprofile ermittelt werden, wie diese aufgrund der vorstehend erläuterten transmissionselektronenmikroskopischen Messungen zu erwarten waren. Völlig überraschend war jedoch, dass massenspektroskopisch kein Kohlenstoff feststellbar war. Dies bedeutet, dass die unter Ethen-Präsenz abgeschiedenen $Al_xTi_{1-x}C_yN_z$-Beschichtungslagen 4 aufgrund des nicht nachweisbaren Kohlenstoffgehaltes als $Al_xTi_{1-x}N$-Beschichtungslagen qualifiziert werden können.

Zerspanungstests

Es wurden mit Beschichtungen auf Basis des Beispiels 1 sowie des Beispiels 2 für eine Spanplatte des Typs RPMX1204 Zerspannungsversuche beim Fräsen von Stählen durchgeführt. Die Schnittdaten waren wie folgt:

$$V_c = 180 \text{ m/min}$$

$$N = 909 \text{ U/min}$$

$$a_p = 2 \text{ mm}$$

$$f_z = 0,25 \text{ mm/Z}$$

$$V_f = 227 \text{ mm/min}$$

$$\kappa = 45°$$

Kühlung: nein

$$D = 63$$

$$Z = 1$$

Analoge Versuche wurden für eine Schneidplatte mit der Bezeichnung SNMX1204 durchgeführt. Beide Schneidplattentypen, sowohl RPMX1204 als auch SNMX1204 waren als Referenz mit herkömmlichen $Al_{1-x}T_xN$-Beschichtungslagen beschichtet, die unter der Marke TeraSpeed bekannt sind. Wie in den nachfolgenden Tabellen 4 und 5 ersichtlich ist, konnte mit Schneidplatten, bei welchen die äußerste Beschichtungslage entsprechend Beispiel 1 (TeraSpeed mit 0,3 slm Ethen) sowie Beispiel 2 (TeraSpeed mit 0,6 slm Ethen) erstellt waren, die Standzeiten um rund 25 % gesteigert werden.

**Tabelle 4**: Zerspanungstests Fräsen mit einem Spanformer RPMX1204

| Sorte Hersteller | Bezeichnung Spanformer | KV [mm] | Verschleiß Vb bei cm³ | | | | | Standzeit |
|---|---|---|---|---|---|---|---|---|
| | | | 250 | 500 | 750 | 1000 | 1250 | |
| **Referenz** Lager BCP30M | RPMX1204 | | 0,082 | 0,102 | 0,134 | 0,171 | | **1000** |
| **TeraSpeed mit 0,3 slm Ethen** | RPMX1204 | | 0,109 | 0,140 | 0,172 | 0,188 | 0,284 | **1250** |
| **TeraSpeed mit 0,6 slm Ethen** | RPMX1204 | | 0,144 | 0,179 | 0,207 | 0,255 | | **1100** |
| **Referenz** Lager BCM40 | RPMX1204 | | 0,085 | 0,105 | 0,108 | Ausbruch | | **850** |
| **TeraSpeed mit 0,3 slm Ethen** | RPMX1204 | | 0,150 | 0,192 | 0,227 | 0,322 | | **1000** |
| **TeraSpeed mit 0,6 slm Ethen** | RPMX1204 | | 0,150 | 0,188 | 0,211 | 0,308 | | **1000** |

**Tabelle 5**: Zerspanungstests Fräsen mit einem Spanformer SNMX1204

| Sorte Hersteller | Bezeichnung Spanformer | KV [mm] | Verschleiß Vb bei cm³ | | | | Stand**zeit** |
|---|---|---|---|---|---|---|---|
| | | | 250 | 500 | 750 | 1000 | |
| **Referenz** Lager BCP30M | SNMX1204 | | | 0,133 | 0,165 | | **750** |
| **TeraSpeed mit 0,3 slm Ethen** | SNMX1204 | | 0,089 | 0,096 | 0,128 | 1,172 | **1000** |
| **TeraSpeed mit 0,6 slm Ethen** | SNMX1204 | | 0,074 | 0,090 | 0,120 | 0,165 | **1000** |

Zusammenfassend ergeben sich mit dem erfindungsgemäßen Verfahren neuartige Strukturen im Bereich von $Al_{1-x}Ti_xN$-Beschichtungslagen, die überraschenderweise trotz einer Präsenz von Ethen im Reaktionsgas kohlenstofffrei ausgebildet sind und zu deutlich verbesserten Standzeiten bei entsprechend beschichteten Werkzeugen wie Schneidplatten führen.

**Patentansprüche**

1. Verfahren zum Beschichten eines Objektes (1), insbesondere eines Schneideinsatzes wie einer Schneidplatte, wobei auf einem Grundkörper (2) eine ein- oder mehrlagige Beschichtung (3) abgeschieden wird, wobei zumindest eine Beschichtungslage mit einem CVD-Verfahren als $Al_xTi_{1-x}C_yN_z$-Beschichtungslage (4) mit Stöchiometriekoeffizienten $0,67 \leq x < 1,0$, $0 \leq y < 0,1$ und $0,9 \leq z \leq 1,15$ abgeschieden wird, wobei die $Al_xTi_{1-x}C_yN_z$-Beschichtungslage in einer Reaktionszone aus einem Gemisch mit einer Vorläuferverbindung für Aluminium, einer Vorläuferverbindung für Titan und einer Vorläuferverbindung für Stickstoff sowie einer kohlenstoffhaltigen Verbindung abgeschieden wird, **dadurch gekennzeichnet, dass** die $Al_xTi_{1-x}C_yN_z$-Beschichtungslage (4) bei einem Druck von mehr als 15 mbar und bei einer Temperatur von 750 °C bis 850 °C und einem molaren Verhältnis der Vorläuferverbindung von Aluminium zu der Vorläuferverbindung von Titan von 5,0 bis 15 und einem molaren Verhältnis der Vorläuferverbindung für Stickstoff zu der kohlenstoffhaltigen Verbindung von 0,5 bis 5,0 abgeschieden wird.

2. Verfahren nach Anspruch 1, **dadurch gekennzeichnet, dass** das molare Verhältnis der Vorläuferverbindung von Aluminium zu der Vorläuferverbindung von Titan 5,5 bis 12,0, vorzugsweise 6,5 bis 11,5, insbesondere 8,0 bis 11,0, beträgt.

3. Verfahren nach Anspruch 1 oder 2, **dadurch gekennzeichnet, dass** auf dem Grundkörper (2) eine Anbindungslage aus Titannitrid abgeschieden wird.

4. Verfahren nach einem der Ansprüche 1 bis 3, **dadurch gekennzeichnet, dass** Ethen als kohlenstoffhaltige Verbindung eingesetzt wird.

5. Verfahren nach einem der Ansprüche 1 bis 4, **dadurch gekennzeichnet, dass** $Al_xTi_{1-x}C_yN_z$-Beschichtungslage (4) mit $y < 0,05$, insbesondere $y \leq 0,01$, vorzugsweise $y \leq 0,001$, abgeschieden wird.

6. Verfahren nach einem der Ansprüche 1 bis 5, **dadurch gekennzeichnet, dass** die $Al_xTi_{1-x}C_yN_z$-Beschichtungslage (4) mit einem molaren Verhältnis der Vorläuferverbindung für Stickstoff zu der kohlenstoffhaltigen Verbindung von 1,0 bis 3,0, vorzugsweise 1,25 bis 2,5, abgeschieden wird.

7. Verfahren nach einem der Ansprüche 1 bis 6, **dadurch gekennzeichnet, dass** die die $Al_xTi_{1-x}C_yN_z$-Beschichtungslage (4) bei einem Druck von 10 mbar bis 150 mbar, vorzugsweise von 20 mbar bis 80 mbar, insbesondere 30 mbar bis 65 mbar, abgeschieden wird.

8. Objekt (1), insbesondere Schneideinsatz wie eine Schneidplatte, erhältlich mit einem Verfahren nach einem der Ansprüche 1 bis 7.

**Fig. 1**

**Fig. 2**

**Fig. 3**

500 nm

Fig. 4

20 nm

**Fig. 5**

Fig. 6

Fig. 7a

Fig. 7b

**Fig. 8a**

**Fig. 8b**

**Fig. 9**

Fig. 10

Fig. 11

Fig. 12

Fig. 13

Fig. 14

Fig. 15

**Fig. 16**

**Fig. 17**

**Fig. 18**

**Fig. 19**

Fig. 20

**Fig. 21**

**Fig. 22**

**Fig. 23**

Europäisches
Patentamt

European
Patent Office

Office européen
des brevets

# EUROPÄISCHER RECHERCHENBERICHT

**Nummer der Anmeldung**

EP 24 16 0350

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | ENDLER I. ET AL: "Aluminum-rich TiAlCN coatings by Low Pressure CVD", SURFACE AND COATINGS TECHNOLOGY, Bd. 205, Nr. 5, 7. September 2010 (2010-09-07), Seiten 1307-1312, XP093186252, NL ISSN: 0257-8972, DOI: 10.1016/j.surfcoat.2010.09.002 | 1,4-6,8 | INV. C23C16/02 C23C16/30 C23C16/34 C23C16/36 C23C28/04 |
| Y | * Tabellen 1-3 * * 2. Experimental; Seite 1308 * ----- | 3 | |
| Y | DE 10 2009 046667 A1 (FRAUNHOFER GES FORSCHUNG [DE]) 19. Mai 2011 (2011-05-19) * Absatz [0022] * * Absatz [0030] - Absatz [0036] * ----- | 3 | |
| A | DE 10 2013 104254 A1 (WALTER AG [DE]) 30. Oktober 2014 (2014-10-30) * Tabellen 3, 4 * * Absatz [0016] * * Absatz [0019] * * Absatz [0012] * ----- | 1-8 | RECHERCHIERTE SACHGEBIETE (IPC) C23C |
| A | EP 3 590 637 A1 (SUMITOMO ELECTRIC HARDMETAL CORP [JP] ET AL.) 8. Januar 2020 (2020-01-08) * Tabelle 3 * * Absatz [0027] - Absatz [0028] * * Absatz [0077] - Absatz [0084] * ----- | 1-8 | |
| A | EP 3 590 636 A1 (SUMITOMO ELECTRIC HARDMETAL CORP [JP] ET AL.) 8. Januar 2020 (2020-01-08) * Tabelle 3 * * Absatz [0027] - Absatz [0028] * * Absatz [0077] - Absatz [0084] * ----- | 1-8 | |

-/--

Der vorliegende Recherchenbericht wurde für alle Patentansprüche erstellt

| Recherchenort | Abschlußdatum der Recherche | Prüfer |
|---|---|---|
| Den Haag | 19. Juli 2024 | Fertig, Andrea |

EPO FORM 1503 03.82 (P04C03)

Seite 1 von 2

Europäisches
Patentamt

European
Patent Office

Office européen
des brevets

# EUROPÄISCHER RECHERCHENBERICHT

**Nummer der Anmeldung**

EP 24 16 0350

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 3 103 572 A1 (MITSUBISHI MATERIALS CORP [JP]) 14. Dezember 2016 (2016-12-14)<br>* Tabelle 4 *<br>* Absatz [0041] - Absatz [0043] *<br>----- | 1-8 | |
| A | CN 111 482 622 A (ZHUZHOU CEMENTED CARBIDE CUTTI) 4. August 2020 (2020-08-04)<br>* Tabellen 1, 3 *<br>* Absatz [0037] - Absatz [0053] *<br>----- | 1-8 | |
| X<br>Y | EP 3 858 524 A1 (MITSUBISHI MATERIALS CORP [JP]) 4. August 2021 (2021-08-04)<br>* Tabellen 2, 7 *<br>* Absatz [0039] - Absatz [0043] *<br>----- | 1,2,4-8<br><br>3 | |
| A | US 2019/358711 A1 (ISHIGAKI TAKUYA [JP] ET AL) 28. November 2019 (2019-11-28)<br>* Tabellen 4, 5, 9, 10 *<br>* Absatz [0117] *<br>----- | 1-8 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 19. Juli 2024 | Fertig, Andrea |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.............................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 24 16 0350

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-07-2024

| Im Recherchenbericht angeführtes Patentdokument | Datum der Veröffentlichung | Mitglied(er) der Patentfamilie | Datum der Veröffentlichung |
|---|---|---|---|
| DE 102009046667 A1 | 19-05-2011 | BR 112012011071 A2 | 30-01-2018 |
| | | CN 102686772 A | 19-09-2012 |
| | | DE 102009046667 A1 | 19-05-2011 |
| | | EP 2499275 A1 | 19-09-2012 |
| | | ES 2436451 T3 | 02-01-2014 |
| | | JP 5583224 B2 | 03-09-2014 |
| | | JP 2013510946 A | 28-03-2013 |
| | | KR 20120102076 A | 17-09-2012 |
| | | RU 2012123952 A | 20-12-2013 |
| | | US 2012219789 A1 | 30-08-2012 |
| | | WO 2011058132 A1 | 19-05-2011 |
| DE 102013104254 A1 | 30-10-2014 | CN 105247099 A | 13-01-2016 |
| | | DE 102013104254 A1 | 30-10-2014 |
| | | EP 2989227 A1 | 02-03-2016 |
| | | ES 2684410 T3 | 02-10-2018 |
| | | JP 6542753 B2 | 10-07-2019 |
| | | JP 2016522323 A | 28-07-2016 |
| | | KR 20160002867 A | 08-01-2016 |
| | | US 2016053372 A1 | 25-02-2016 |
| | | WO 2014173755 A1 | 30-10-2014 |
| EP 3590637 A1 | 08-01-2020 | CN 110382145 A | 25-10-2019 |
| | | EP 3590637 A1 | 08-01-2020 |
| | | JP 6831449 B2 | 17-02-2021 |
| | | JP WO2018158975 A1 | 08-08-2019 |
| | | KR 20190112038 A | 02-10-2019 |
| | | US 2020061717 A1 | 27-02-2020 |
| | | WO 2018158975 A1 | 07-09-2018 |
| EP 3590636 A1 | 08-01-2020 | CN 110352107 A | 18-10-2019 |
| | | EP 3590636 A1 | 08-01-2020 |
| | | JP 6831448 B2 | 17-02-2021 |
| | | JP WO2018158974 A1 | 08-08-2019 |
| | | KR 20190112037 A | 02-10-2019 |
| | | US 2020061718 A1 | 27-02-2020 |
| | | WO 2018158974 A1 | 07-09-2018 |
| EP 3103572 A1 | 14-12-2016 | CN 106457413 A | 22-02-2017 |
| | | EP 3103572 A1 | 14-12-2016 |
| | | JP 5924507 B2 | 25-05-2016 |
| | | JP 2016064485 A | 28-04-2016 |
| | | KR 20170057375 A | 24-05-2017 |
| | | US 2017297117 A1 | 19-10-2017 |
| | | WO 2016047581 A1 | 31-03-2016 |

EPO FORM P0461

Für nähere Einzelheiten zu diesem Anhang : siehe Amtsblatt des Europäischen Patentamts, Nr.12/82

Seite 1 von 2

**ANHANG ZUM EUROPÄISCHEN RECHERCHENBERICHT
ÜBER DIE EUROPÄISCHE PATENTANMELDUNG NR.**

EP 24 16 0350

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-07-2024

| Im Recherchenbericht angeführtes Patentdokument | Datum der Veröffentlichung | Mitglied(er) der Patentfamilie | Datum der Veröffentlichung |
|---|---|---|---|
| CN 111482622 A | 04-08-2020 | KEINE | |
| EP 3858524 A1 | 04-08-2021 | EP 3858524 A1 | 04-08-2021 |
| | | US 2021402486 A1 | 30-12-2021 |
| | | WO 2020067402 A1 | 02-04-2020 |
| US 2019358711 A1 | 28-11-2019 | CN 110191777 A | 30-08-2019 |
| | | JP 7098932 B2 | 12-07-2022 |
| | | JP 2018114611 A | 26-07-2018 |
| | | US 2019358711 A1 | 28-11-2019 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03085152 A2
- US 6238739 B1
- DE 102007000512 B3

- WO 2013134796 A1
- WO 2016112417 A1
- WO 2023164731 A1

**In der Beschreibung aufgeführte Nicht-Patentliteratur**

- **I. ENDLER et al.** *Proceedings Euro PM 2006, Ghent, Belgien*, 23 October 2006, vol. 1, 219
- **M. MEINDLHUMER et al.** Biometic hard and tough nanoceramic Ti-Al-N film with selfassembled 6-level hierarchy. *nanoscale*, 2019, vol. 16, 7986

- **I. ENDLER et al.** Aluminium-rich TiAlCN coatings by Low Pressure CVD. *Surface & Coatings Technology*, 2010, vol. 205, 1307